# EUROPÄISCHE PATENTSCHRIFT

(11) **EP 0 914 483 B1**
(45) Veröffentlichungstag und Bekanntmachung des Hinweises auf die Patenterteilung: **23.08.2000**
(21) Anmeldenummer: 97921574.6
(22) Anmeldetag: 26.05.1997
(51) Int. Cl.: C22C 19/05, C30B 11/00, C30B 29/52

(54) **NICKEL-BASIS-SUPERLEGIERUNG**
NICKEL-BASE SUPERALLOY
SUPERALLIAGE A BASE DE NICKEL

(30) Priorität: 17.06.1996 DE 19624055
(43) Veröffentlichungstag der Anmeldung: 12.05.1999
(73) Patentinhaber: ABB ALSTOM POWER (Schweiz) AG, 5401 Baden (CH)
(72) Erfinder: KONTER, Maxim, Dr., CH-5313 Klingnau (CH); NEWNHAM, Michael, Malvern, Worcestershire WR13 5DN (GB); TÖNNES, Christoph, CH-5313 Klingnau (CH)
(74) Vertreter: Pöpper, Evamaria, Dr.
(86) Internationale Anmeldenummer: CH9700210
(87) Internationale Veröffentlichungsnummer: WO9748827

(56) Entgegenhaltungen:
- EP-A- 0 155 827
- EP-A- 0 208 645
- EP-A- 0 240 451
- WO-A-93/24683
- GB-A- 2 235 697
- US-A- 5 100 484
- US-A- 5 470 371
- JOURNAL OF MATERIALS ENGINEERING AND PERFORMANCE, Bd. 2, Nr. 4, August 1993, MATERIALS PARK US, Seiten 481-487, XP000394071 K.HARRIS ET AL: "DEVELOPMENT OF TWO RHENIUM-CONTAINING SUPERALLOYS FOR SINGLE-CRYSTAL BLADE AND DIRECTIONALLY SOLIDIFIED VANE APPLICATIONS IN ADVANCED TURBINE ENGINES"

## Beschreibung

### Technisches Gebiet

Die Erfindung betrifft eine Nickel-Basis-Superlegierung, insbesondere zur Herstellung von Einkristall-Komponenten.

### Stand der Technik

Derartige Nickel-Basis-Superlegierungen sind bekannt. Aus diesen Legierungen werden Einkristall-Komponenten hergestellt, insbesondere Turbinenschaufeln von Gasturbinen. Mittels dieser Einkristall-Komponenten kann die Materialfestigkeit bei hohen Temperaturen maximiert werden. Dadurch kann die Einlasstemperatur von Gasturbinen erhöht werden, wodurch die Effizienz der Gasturbine steigt.

Einkristall-Legierungen, wie sie aus US 4,643,782, CH 637 165, EP 0 076 360, US 5,270,123 und EP 0 208 645 bekannt sind enthalten dazu mischkristallverfestigende Elemente wie Re, W, Mo, Co, Cr, sowie γ'-Phasen bildende Elemente wie Al, Ta und Ti. Der Gehalt an hochschmelzenden Legierungselementen in der Grund-Matrix Ni nimmt kontinuierlich zu mit der Zunahme der benötigten Gebrauchstemperatur der Legierungen. Ueblicherweise enthält eine Einkristall-Legierung (in Gew.-%): 6 - 8% W, bis zu 6% Re und bis zu 2% Mo. Die in den obengenannten Schriften beschriebenen Legierungen zeigen eine hohe Kriechfestigkeit, gute LCF- (Ermüdung bei niedriger Lastspielzahl) und HCF-Eigenschaften (Ermüdung bei hoher Lastspielzahl) wie auch einen hohen Oxidationswiderstand.

Diese bekannten Legierungen wurden für Flugzeug-Turbinen entwickelt und deshalb optimiert auf kurz- und mittelzeit Eigenschaften, d.h. die Gebrauchsdauer wird auf bis zu 20000 Stunden ausgelegt. Im Gegensatz dazu müssen industrielle Gasturbinen-Komponenten auf eine Gebrauchsdauer von bis zu 75000 Stunden ausgelegt werden. Durch die Optimierung auf eine maximale Zeitstandfestigkeit bei hohen Temperaturen und hohen Spannungen weisen diese Legierungen ein positives Wärmebehandlungsfenster auf, d.h die primäre γ'-Phase wird voll gelöst ohne örtliches Voraufschmelzen der Legierung.

So zeigt eine Legierung "CMSX-4" aus US 4,643,782 bei der Verwendung in industriellen Gasturbinen zwar einen guten Kriechwiderstand, jedoch eine hohe Anfälligkeit auf die Bildung von Kleinwinkelkorngrenzen, von "Frecklen", das sind Fehlstellen bedingt durch eine Kette von gleichgerichteten Körnern mit einen hohen Gehalt an Eutektikum, sowie einer ausgedehnten Rekristallisation der Einkristall-Komponenten während dem Lösungsglühen. Nach einer Betriebsdauer von 3000 Stunden bei Temperaturen oberhalb 1000°C zeigt die Legierung eine starke Vergröberung der γ'-Struktur, gefolgt von einer Erhöhung der Kriechgeschwindigkeit.

Aus CH 637 165, EP 0 208 645 sowie aus "Second generation nickel-base superalloy", A.D. Cetel et al., Superalloys 1988, ed. S. Reichman et al, Met. Soc., 1988, S. 235, sind Legierungen mit der Bezeichnung "PWA", insbesondere "PWA 1484", und aus EP 0 076 360 und US 5,270,123 sind Legierungen mit der Bezeichnung "René", insbesondere "René N5", bekanntgeworden, die jedoch vergleichbare Nachteile aufweisen wie die Legierung CMSX-4.

Durch die gewählten Zulegierungselemente wird in den obengenannten Legierungen ein positiver oder negativer Gitterversatz zwischen γ-Phase und γ'-Phase erzeugt. Durch die Gitterverzerrung werden Versetzungen beim Gleiten oder Schneiden von γ'-Körnern behindert. Diese Gitterverzerrung bewirkt zwar eine Erhöhung der Kurzzeitfestigkeit, bewirkt aber auch bei längerer Belastung eine Vergröberung des Gefüges und entsprechend eine langfristige mechanische Schwächung der Legierung.

### Darstellung der Erfindung

Der Erfindung liegt die Aufgabe zugrunde, bei einer Nickel-Basis-Superlegierung der eingangs genannten Art das Langzeitverhalten bei hohen Gebrauchstemperaturen zu verbessern und eine hohe Ausbeute an mit dieser Legierung hergestellten Komponenten zu erhalten.

Erfindungsgemäss wird dies durch die Merkmale des ersten Anspruches erreicht.

Kern der Erfindung ist es also, dass die Nickel-Basis-Superlegierung im wesentlichen aus (gemessen in Gew.-%) 6.0-6.8% Cr, 8.0-10.0% Co, 0.5-0.7% Mo, 6.2-6.6% W, 2.7-3.2% Re, 5.4-5.8% Al, 0.5-0.9% Ti, 7.2-7.8% Ta, 0.15-0.3% Hf, 0.02-0.04% C, 40-100 ppm B, 0-400 ppm Y, Rest Nickel mit Verunreinigungen, wobei das Verhältnis (Ta + 1.5 Hf + 0.5 Mo - 0.5 Ti) / (W + 1.2 Re) ≥ 0.7 ist, besteht.

Die Vorteile der Erfindung sind unter anderem darin zu sehen, dass die Legierung eine perfekte Giessbarkeit, eine grosse Phasenstabilität kombiniert mit besten mechanischen Eigenschaften aufweist. Sie zeichnet sich zudem durch eine hohe Dauerfestigkeit und Kriechstabilität auch bei Langzeitbelastung aus.

Die erfindungsgemässen Legierungen weisen bei Betriebstemperatur keinen Gitterversatz zwischen γ-Phase und γ'-Phase auf, wodurch eine hohe Langzeitstabilität bei mässiger Belastung erreicht wird.

Die Legierung zeichnet sich durch eine geringe Neigung zur Rekristallisation während Wärmebehandlungen und durch eine geringe Neigung zur Bildung von Frecklen aus. Die Bildung von Frecklen wird durch eine ausgewogene chemische Zusammensetzung erreicht, mittels derer Dichtedifferenzen des flüssigen Metalls in der breiartigen Zone und oberhalb der Erstarrungsfront vermieden werden.

Die erfindungsgemässe Legierung zeichnet sich durch ein negatives Wärmebehandlungsfenster aus, wodurch schmelzpunktsenkende Elemente wie B und Hf, welche vorteilhaft für die Ausbeute bei der Herstellung von Einkristallkomponenten sind, verwendet werden können. Zudem kann der Gehalt an γ'-phasenstabilisierende Elemente und vorallem Ta auf die Langzeitstabilität der Struktur und der Eigenschaften der Legierung bei hohen Temperaturen und mässiger Spannungen ausgelegt werden.

Weitere vorteilhafte Ausgestaltungen der Erfindung ergeben sich aus den Unteransprüchen.

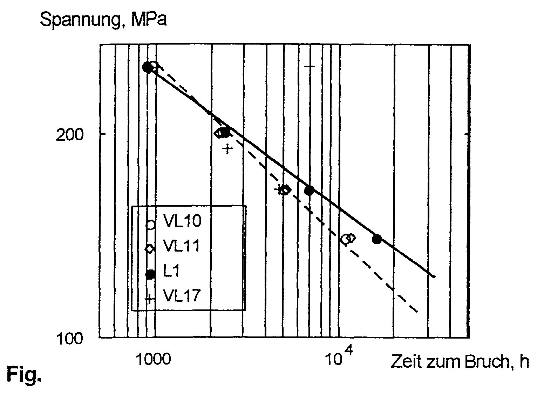

### Kurze Beschreibung der Zeichnung

In der einzigen Zeichnung ist ist die Zeit bis zum Bruch gegen die angelegte Spannung für eine erfindungsgemässe Legierung im Vergleich mit bekannten Legierungen dargestellt.

### Weg zur Ausführung der Erfindung

Die erfindungsgemässe Legierung, welche zur Herstellung von Einkristall-Komponenten oder gerichtet erstarrten Komponenten für industrielle Gasturbinen verwendet wird, besteht im wesentlichen aus (in Gew.-%):

| | |
|---|---|
| Cr | 6.0 - 6.8 |
| Co | 8.0 - 10.0 |
| Mo | 0.5 - 0.7 |
| W | 6.2 - 6.6 |
| Re | 2.7 - 3.2 |
| Al | 5.4 - 5.8 |
| Ti | 0.5 - 0.9 |
| Ta | 7.2 - 7.8 |
| Hf | 0.15-0.3 |
| C | 0.02 - 0.04 |
| B | 40 - 100 ppm |
| Ni | Rest |

sowie unvermeidbare Verunreinigungen.

Diese Nickelbasis-Superlegierung zeichnet sich aus durch eine einmalige Kombination von Giessbarkeit von grossen Einkristallkomponenten, gesteigerter Langzeit-Stabilität der Legierungsstruktur und hohen mechanischen Eigenschaften bei mässigen Belastungen bei Temperaturen von 850 bis 1050°C.

In der Tabelle 1 sind erfindungsgemässe Legierungen L1, L2, L3 und L4 Vergleichslegierungen VL10 bis VL19 gegenübergestellt, deren chemische Zusammensetzung ausserhalb der erfindungsgemässen Zusammensetzung liegt. Die Vergleichslegierungen VL17, VL18 und VL19 sind dabei kommerziell verwendete Legierungen mit den Handelsbezeichnungen CMSX-4, René N5 und PWA1484, entsprechend den eingangs gemachten Angaben.

Die Legierungen L1 bis L4 und VL10 bis VL16 besitzen ein negatives Wärmebehandlungsfenster und wurden deshalb nach dem Guss in einem mehrfachen Zyklus lösungsgeglüht. Die maximale Lösungsglühtemperatur betrug dabei 1310°C, das ist 10 bis 15°C unterhalb der γ'-Solvus-(Löslichkeitskurve für den festen Zustand im Zustandsschaubild)-Temperatur. Bei der Legierung VL17 wurde die γ'-Phase zu 99.5% gelöst. Alle Legierungen wurden danach bei 1140- 1150°C während 4 Stunden und bei 870°C während 20 Stunden auscheidungsgehärtet

Nach einer Homogenisierungsglühbehandlung weisen Nickel-Basis-Superlegierungen üblicherweise einen Gitterversatz zwischen γ-Gitter und γ'-Gitter auf. In Tabelle 2 sind die Versätze unterschiedlicher Legierungen dargestelt. VL10 und VL19 weisen einen positiven Versatz auf, VL11, VL17 und VL18 weisen einen negativen Versatz auf. Ein positiver oder negativer Versatz resultiert in einem zusätzlichen Spannungsfeld um die γ'-Körner und erhöht damit den Widerstand gegen Schneiden oder Klettern von Versetzungen während dem Kriechen. Dies ist wichtig für Komponenten, welche bei hohen Belastungen und hohen Temperaturen verwendet werden. Langfristig entsteht jedoch durch den Gitter-Versatz bei hohen Temperaturen und mässiger oder tiefer Belastung eine Korn-Vergröberung und anschliessend eine Degradation der γ'-Struktur. Dies führt zu einer Reduktion der Kriecheigenschaften bei Verwendung derartiger Komponenten oberhalb 20000 Betriebstunden.

Die Legierungen L1 bis L4 mit einer γ/γ'-Struktur mit keinem Gitterversatz weisen in der Kurzzeitbetrachtung eine geringere Festigkeit auf als die Vergleichslegierungen VL mit einem Gitterversatz. Beim Langzeitbetrieb bei hohen Temperaturen weisen die Legierungen L1 bis L4 jedoch eine viel höhere Stabilität auf. Der Gitterversatz der γ/γ'-Struktur wird erfindungsgemäss durch Tantal ausgeglichen, welches einen Nemstschen Verteilungskoeffizienten in der γ/γ'-Struktur von 0.22 aufweist, Ta ist damit ein starker γ'-Bildner. Die Ta-Atome ersetzen im γ'-Gitter die Al-Atome und ändern den Gitterparameter des γ'-Gitters durch den grossen Atomradius der Ta-Atome. Entsprechend Tabelle 2 weisen Legierungen mit einem Tantal-Gehalt von weniger als 7% einen negativen, mit einem Ta-Gehalt von 7 bis 8% keinen und mit einem Ta-Gehalt von mehr als 8% einen positiven Gitterversatz auf.

Der Einfluss des Gitterversatzes auf das Langzeit-Kriechverhalten ist in der Tabelle 3 dargestellt. Die Vergleichslegierungen VL10, VL11 und VL17 haben ein besseres Kurzzeit-Kriechverhalten verglichen mit den Legierungen L1, L3 und L4. Bei mässigen Belastungen sind die Langzeit-Eigenschaften der Legierungen L1, L3 und L4 jedoch signifikant höher.

In der einzigen Figur ist die Zeit bis zum Bruch gegen die angelegte Spannung bei jeweils 950°C aufgetragen. Aus der Figur ist ersichtlich, dass die erfindungsgemässe Legierung L1 bei längerdauernder Belastung eine höhere Spannung ertragen kann als die Vergleichslegierungen, die einen positiven VL10 oder einen negativen VL11, VL17 Gitterversatz aufweisen.

Die Zusammensetzung der Legierungselemente in der vorliegenden Erfindung wird durch Ausscheidungen von spröden, Re-Cr-reichen, topologisch dicht gepackten Phasen eingeschränkt. Diese Phasen entstehen, wenn der Gehalt an Cr, Mo, W, Re oder von γ'-bildenden Elementen höher liegt als erfindungsgemäss spezifiziert. So bildet die Vergleichslegierung VL15 nadelförmige, Re-Cr-reiche Ausscheidungen nach einer Alterung bei 1000°C während 1000h. Diese Ausscheidung haben eine Verschlechterung der mechanischen Eigenschaften, speziell der LCF-Eigenschaften (Tabelle 3) der Vergleichslegierung zur Folge. Andererseits haben die Vergleichslegierungen, deren Gehalt an Cr, Mo, W, Re oder von γ'-bildenden Elementen tiefer liegt als erfindungsgemäss spezifiziert, einen schlechten Kriechwiderstand wegen des geringen Anteiles an γ'-Phase und eine relativ schwache γ-Matrix, wie beispielsweise die VL16 gemäss der Tabelle 3.

Die Bildung von Frecklen, das sind Fehlstellen bedingt durch eine Kette von gleichgerichteten Körnern mit einen hohen Gehalt an Eutektikum, ist ein üblicher Defekt in grossen Einkristall-Gussteilen. Die Freckle-Bildung ist einer Fliessbewegung der interdendritischer Flüssigkeit bei der Erstarrung zuzuschreiben. Die Fliessbewegung wird durch unstabile Dichteverteilungen angetrieben, wenn die interdendritische Flüssigkeit leichter ist als die Flüssigkeit mit der nominalen Zusammensetzung. Für die Herstellung von grösseren Einkristall-Gussteilen ist es deshalb wichtig, die chemische Zusammensetzung der Legierung auszugleichen, um die Dichtedifferenz zwischen flüssigem Metall in der breiartigen Zone und oberhalb der Erstarrungszone vernachlässigbar zu machen. Elemente wie Ta, Mo, und Hf seigern in der breiartigen Zone während der Verfestigung in die interdendritische Flüssigkeit und erhöhen deren Dichte. Im Gegensatz dazu senkt das ebenfalls in die interdendritische Flüssigkeit seigernde Ti die Dichte. Schwere Elemente wie W und Re seigern stark in die Dentrite, weshalb die interdendritische Flüssigkeit in W/Re-reichen Legierungen eine starke Tendenz dazu hat, leichter zu sein als die Flüssigkeit mit nominaler Zusammensetzung.

Idealerweise sollte die interdendritische Flüssigkeit schwerer sein als die Flüssigkeit oberhalb der Erstarrungszone. Dadurch fliesst keine Flüssigkeit gegen die Erstarrungszone, d.h. es entsteht keine Fliessbewegung und damit keine Freckle. Diese Bedingung kann empirisch durch einen "Keine-Freckle-Parameter" NFP beschrieben werden:

NFP = (Ta + 1.5 Hf + 0.5 Mo - 0.5 Ti) / (W + 1.2 Re) ≥ 1, {1}

Die Koeffizienten widerspiegeln den Segregations-Quotienten und das atomare Gewicht des jeweiligen Elements. In einem realen System spielen jedoch zusätzliche Faktoren und Prozessparameter bei der Bildung oder Behinderung von Frecklen eine Rolle.

Die kritische Bedingung des flüssigen Metalls zur Bildung von Freckle-Ketten kann durch die Stokes-Gleichung und einer Abhängigkeit der Wachstumsrate aus "The origin of freckles in unidirectionally solidified casting", S. M. Copley et al., Met. Trans., August 1970, S. 2193, beschrieben werden:

I_{crit} = W∗τ = (2/9)∗(Δρ/µr)∗(ΔT / (Gₛ∗Vₛ)) [cm] {2}

wobei:
Δρ = ρ Flüssigkeit oberhalb breiartiger Zone. -
   ρ interdendritische Flüssigkeit [kg/m³]
µ : Viskosität des flüssigen Metalls
r: Diameter des Transportkanales

r ≈ A ∗ DAS = A ∗ K / (G_{L}^{0.5}∗V_{L}^{0.25}), {3}

A ≈ 0.3, K ist eine Material-Konstante
G_{L} : Temperatur-Gradient an der Liquidus-Front
V_{L} : Liquidus-Front Geschwindigkeit
ΔT: Erstarrungsbereich
Gₛ : Temperaturgradient in der breiartigen Zone
Vₛ : Erstarrungsrate

Um den Einfluss der Prozessparameter auf die Freckle-Bildung vom Einfluss der Legierungszusammensetzung zu trennen, kann die Formel {2} unter Zuhilfenahme der Formel {3} geschrieben werden. Dies unter der Annahme, dass die Viskosität des flüssigen Metalls viel mehr von der Temperatur als von der Veränderung der Legierungselemente abhängt.

I_{crit} = (2/9A)∗(G_{L}^{0.5}∗V_{L}^{0.25}/(µ∗Gₛ∗Vₛ))∗(Δρ∗ΔT/K) {4}

Der unterstrichene Teil der Formel {4} repräsentiert den Einfluss der Legierungszusammensetzung.

Neben Δρ, dessen Grösse unter Benützung von Formel {1} abgeschätzt werden kann, spielt die Material-Konstante K im Zusammenhang mit der Torqueosität der interdendritischen Kanäle in der breiartigen Zone eine wichtige Rolle. Zeilenförmige Karbide vom Typ (Hf, Ta)C in den interdendritischen Gebieten erhöhen die Konstante K erheblich. Im Gegensatz dazu ist der Erstarrungsbereich ΔT, berechnet als Differenz zwischen dem Start- und dem Endpunkt der Erstarrung in der DTA-(differenzielle thermische Analyse)-Kühlkurve, für alle fortschrittlichen Einkristall-Legierungen oder gerichtet erstarrten Legierungen unabhängig von den Legierungselementen ungefähr gleich, wie dies aus der Tabelle 4, Spalte ΔTc hervorgeht.

Aus den Legierungen L1, L2, VL12, VL13 und VL17 wurden 270 mm lange Schaufeln mit einem vollwandigen Fuss gegossen. Die Gussparameter wurden für alle Versuche gleich gehalten, die Entnahmegeschwindigkeit betrug 4 mm/min für das Schaufelblatt und 2.5 mm/min für den Schaufelfuss, um eine einkristalline Schaufel zu erhalten. Diese Giessbedingungen sind typisch für die industrielle Produktion von vollwandigen einkristallinen Schaufeln. Nach dem Guss wurden die Schaufeln wärmebehandelt. Die Schaufeln aus den Legierungen L1, L2, VL12 und VL13 wurden bei 1310°C lösungsgeglüht, die Schaufel aus der Legierung VL17 wurde zu 99.5% lösungsgeglüht und alle Schaufeln geprüft. Die Schaufeln aus den Legierungen L1, L2, VL12 und VL13 zeigten keine Rekristallisation, während die Schaufel aus der Legierung VL17 Rekristallisation der einkristallinen Struktur zeigte.

Gemäss der Tabelle 4 zeigen Legierungen mit einem NFP < 0.70 eine Neigung zur Bildung von Frecklen. Dies ist auch bei Legierungen mit einem NFP ≥ 0.70 mit eine Kohlenstoffgehalt unter 200 ppm und einem Hafniumgehalt überhalb 0.15 Gew.-% der Fall, wie beispielsweise bei der VL12.

Variationen des Erstarrungsbereiches ΔT sind unbedeutend. Die Legierungen VL19 und VL20 (MM-247 DS, gerichtet erstarrt) wurden nicht gegossen, aber sie illustrieren durch ihre unterschiedliche chemische Zusammensetzung (VL20: reich an C, B, Hf, kein Re; VL19: hoher Mo-Gehalt, kein Ti) die These das der Erstarrungsbereich für verschiedenen hochlegierte Superlegierungen ungefähr gleich ist.

Aus den Versuchen folgt, dass bei üblichen Giessbedingungen für vollwandige Teile von Gasturbinen eine freckle-freie Legierung folgende Bedingungen zu erfüllen hat (dies, falls der NFP nicht grösser als 1 ist, entsprechend Formel {1}):

NFP = (Ta + 1.5 Hf + 0.5 Mo - 0.5 Ti)/(W + 1.2 Re) ≥ 0.7 {5}

und
C ≥ 200 ppm; Hf ≥ 0.15 Gew.-%.

Andererseits ist der gewünschte Gehalt von Hf und C in der Einkristall-Legierung eingeschränkt auf C ≤ 400 ppm und Hf ≤ 0.3% wegen dem schädlichen Einfluss von zeilenartigen (Hf, Ta, Ti)C Karbiden und Voraufschmelzung von Hf-reichem Eutektikum auf die LCF-Eigenschaften. Analysen mit dem Rasterelektronenmikroskop von LCF-Proben haben gezeigt, dass Zeilen-Karbide und Voraufschmelzungsporosität der Hauptgrund für die geringe LCF-Lebensdauer der Vergleichslegierung VL14 im Vergleich mit den Legierungen L1, L3 und L4 in der Tabelle 3.

Das schmelzpunktsenkende Element Bor wird in einem Gehalt von 40 bis 100 ppm zulegiert. Wenn der Gehalt an B ungenügend ist, werden schädliche, grobe Karbide ausgeschieden. Dies hat schlechten LCF-Eigenschaften zur Folge. Wird der B -Gehalt zu sehr erhöht, bilden sich Eutektika mit einem tiefen Schmelzpunkt. Dies hat ebenfalls schlechte LCF-Eigenschaften zur Folge.

Als weitere Elemente können Magnesium und Yttrium zulegiert werden. Durch eine geringe Zulegierung von Mg, ungefähr 10 bis 20% des C-Gehaltes, d.h. 15 bis 50 ppm Mg, entstehen in Kombination mit B und Hf in den erfindungsgemässen Legierungen feine und inselförmige Karbide. Die Verteilung der Karbide im Legierungsvolumen ist inhomogen an den Kleinwinkelkorngrenzen konzentriert. Durch das Mg, das stark an die Korngrenzen seigert, wird die Segregation der karbidbildenden Elemente Hf, Ta und Ti beeinflusst und das Mg tritt in Wechselwirkung mit diesen Elementen. Der grosse Atomradius von Mg verursacht eine starke Gitterverzerrung an den Kleinwinkelkorngrenzen, was die Segregation von C in die Kleinwinkelkorngrenzen erleichtert. Die daraus entstehende feine und dichte Karbo-Borid-Struktur entlang den Korngrenzen verbessert die transversalen Eigenschaften und gleichzeitig die Dauerfestigkeit der Einkristall-Komponenten. Wenn der Mg-Gehalt 50 ppm übersteigt, nehmen die transversalen mechanischen Eigenschaften stark ab. Dies ist auf die Bildung von grossen Karbiden und Ni-Mg-Verbindungen entlang der Korngrenzen zurückzuführen.
Yttrium verbessert die Oxidations- und Korrosionsbeständigkeit in Gehalten bis zu 400 ppm, insbesondere in Gehalten von 10 bis 400 ppm. Durch höhere Y-Gehalte fällt die Duktilität ab. Y dotierte Legierungen benötigen jedoch eine spezielle Giess-Technik, um eine Reaktion zwischen Giessform und Metall zu verhindern.

Die erfindungsgemässen Legierungen eignen sich hervorragend, um mit einem Wärmebehandlungsverfahren behandelt zu werden, dass folgende Schritte umfasst: Glühen bei 850°C bis 1100°C, insbesondere bei 930°C bis 970°C während 1 bis 4 Stunden und bei 1030°C bis 1070°C während 2 bis 20 Stunden, erwärmen auf 1200°C, erwärmen auf eine Temperatur 1200°C<T≤1300°C mit einer Aufheizrate kleiner gleich 1°C/min, insbesondere mit einer Aufheizrate von etwa 0.5°C/min, einem mehrstufigen Homogenisierungs- und Lösungsprozess bei einer Temperatur 1300°C ≤ T ≤ 1315°C, insbesondere bei etwa 1300°C während etwa 2 Stunden und anschliessend bei etwa 1310°C während 6 bis 12 Stunden.

Die Vorteile der Wärmebehandlung sind unter anderem darin zu sehen, dass durch das Verfahren Versetzungsquellen geschlossen und damit die Erzeugung weiterer Versetzungen verhindert wird. Weiter wird eine Rekristallisation währen dem Aufheizprozess vermieden und die Annihilation des Versetzungs-Netzwerkes forciert. Durch den mehrstufigen Homogenisierungs- und Lösungsprozess entsteht eine sehr gute Homogenisierung der Werkstoffkörper. Das verbleibende Eutektikum von 1 bis 4 Vol.-% reicht aus um die Korngrenzen von Rekristallisationskörner zu pinnen.

Selbstverständlich ist die Erfindung nicht auf das gezeigte und beschriebene Ausführungsbeispiel beschränkt. Komponenten aus dieser Legierung können auch in andere Maschinen eingebaut werden, wo bei hohen Temperaturen eine stabile Struktur und hohe mechanische Eigenschaften im Langzeitbetrieb benötigt werden.

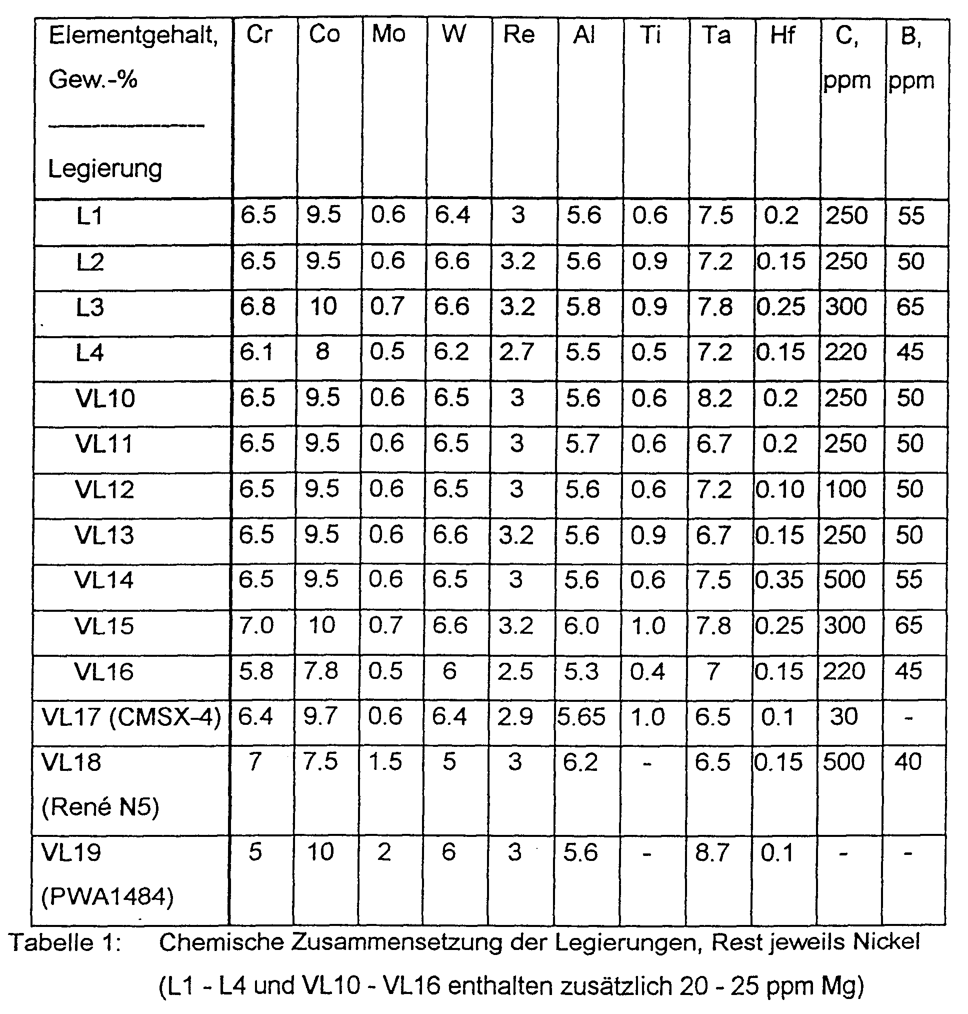

**Tabelle 2:**

| Gitterparameter | | | | |
|---|---|---|---|---|
| Legierung | Ta, Gew.-% | aγ, Å | aγ', Å | Gitterversatz, aγ'-aγ, Å |
| L1 | 7.5 | 3.588 | 3.588 | 0 |
| L3 | 7.8 | 3.590 | 3.590 | 0 |
| L4 | 7.2 | 3.587 | 3.587 | 0 |
| VL10 | 8.2 | 3.587 | 3.591 | 0.004 |
| VL11 | 6.7 | 3.588 | 3.586 | - 0.002 |
| VL17 (CMSX-4) | 6.5 | 3.590 | 3.586 | - 0.004 |
| VL18 (René N5) | 6.5 | 3.586 | 3.583 | - 0.003 |
| VL19 (PWA 1484) | 8.7 | 3.584 | 3.590 | 0.006 |

**Tabelle 3:**

| Kriechbruchfestigkeit and LCF-Eigenschaften | | | | | |
|---|---|---|---|---|---|
| | Zeit zum Bruch, h bei 950 °C und jeweils: | | | | N_{f} bei 1000°C, Zyklen (nach Alterung 1000°C/1000h) |
| Legierung | 250 MPa | 200 MPa | 165 MPa | 140 MPa | Δεₜₒₜ = 0.9% |
| L1 | 880 | 2388 | 6815 | >15000 | 4214 |
| L3 | 895 | 2467 | 6910 | - | 4337 |
| L4 | 847 | 2138 | 6050 | - | 3896 |
| VL10 | 947 | 2280 | 5040 | 11700 | - |
| VL11 | 918 | 2203 | 5180 | 12614 | - |
| VL14 | - | - | - | - | 2215 |
| VL15 | - | 2250 | 4430 | - | 1540 |
| VL16 | - | 1990 | 3690 | - | - |
| VL17 (CMSX-4) | 1018 | 2438 (bei 190 MPa) | 4760 | - | 3365 |

**Tabelle 4:**

| Freckle-Anfälligkeitsparameter und Resultate von Gussproben | | | | | | |
|---|---|---|---|---|---|---|
| Gegossene Schaufeln aus Legierung | NFP | C, ppm | Hf, Gew.-% | Gehalt an Zeilen-Karbiden, vol.% | ΔTc, K | Freckle-Ketten im Schaufel fuss |
| L1 | 0.78 | 250 | 0.20 | 0.4 | 96 | keine |
| L2 | 0.70 | 250 | 0.15 | 0.4 | 96 | keine |
| VL12 | 0.73 | 100 | 0.10 | - | 94 | 11 |
| VL13 | 0.65 | 250 | 0.15 | 0.4 | 96 | 8 |
| VL17 (CMSX-4) | 0.65 | 30 | 0.10 | - | 93 | > 30 |
| Referenzproben: | | | | | | |
| VL19 (PWA 1484) | 1.05 | (-) | 0.10 | - | 88 | Freckle frei |
| VL20 (MM-247 DS) | 0.51 | 1500 | 1.3 | > 2 | 103 | Freckle prone |

## Patentansprüche

1. Nickel-Basis-Superlegierung, insbesondere zur Herstellung von Einkristall-Komponenten, umfassend (gemessen in Gew.-%):
6.0-6.8% Cr, 8.0-10.0% Co, 0.5-0.7% Mo, 6.2-6.6% W, 2.7-3.2% Re, 5.4-5.8% Al, 0.5-0.9% Ti, 7.2-7.8% Ta, 0.15-0.3% Hf, 0.02-0.04% C, 40-100 ppm B, wahlweise 15-50 ppm Mg 0-400 ppm Y, Rest Nickel mit Verunreinigungen,
wobei das Verhältnis (Ta + 1.5 Hf + 0.5 Mo - 0.5 Ti) / (W + 1.2 Re) ≥ 0.7 ist.

2. Nickel-Basis-Superlegierung nach Anspruch 1,
gekennzeichnet durch eine Zusammensetzung bestehend aus (in Gew.-%): 6.4-6.6% Cr, 9.4-9.6% Co, 0.6% Mo, 6.4-6.6% W, 3.0-3.2% Re, 5.6% Al, 0.6-0.9% Ti, 7.2-7.5% Ta, 0.15-0.2% Hf, 0.02-0.03% C, 50-60 ppm B, Rest Nickel mit Verunreinigungen.

3. Nickel-Basis-Superlegierung nach Anspruch 1 oder 2,
dadurch gekennzeichnet,
dass 15-50 ppm Mg und / oder 10-400 ppm Y vorliegt.

4. Nickel-Basis-Superlegierungs-Einkristallkomponente, bestehend aus (gemessen in Gew.-%):
6.0-6.8% Cr, 8.0-10.0% Co, 0.5-0.7% Mo, 6.2-6.6% W, 2.7-3.2% Re, 5.4-5.8% Al, 0.5-0.9% Ti, 7.2-7.8% Ta, 0.15-0.3% Hf, 0.02-0.04% C, 40-100 ppm B, wahlweise 15-50 ppm Mg 0-400 ppm Y, Rest Nickel mit Verunreinigungen,
wobei das Verhältnis (Ta + 1.5 Hf + 0.5 Mo - 0.5 Ti) / (W + 1.2 Re) ≥ 0.7 ist.

5. Nickel-Basis-Superlegierungs-Einkristallkomponente nach Anspruch 4,
gekennzeichnet durch eine Zusammensetzung bestehend aus (in Gew.-%): 6.4-6.6% Cr, 9.4-9.6% Co, 0.6% Mo, 6.4-6.6% W, 3.0-3.2% Re, 5.6% Al, 0.6-0.9% Ti, 7.2-7.5% Ta, 0.15-0.2% Hf, 0.02-0.03% C, 50-60 ppm B, Rest Nickel mit Verunreinigungen.

6. Nickel-Basis-Superlegierungs-Einkristallkomponente nach Anspruch 4 oder 5, dadurch gekennzeichnet,
dass 15-50 ppm Mg und / oder 10-400 ppm Y vorliegt.

7. Nickel-Basis-Superlegierungs-Einkristallkomponente nach Anspruch 4 oder 5, dadurch gekennzeichnet,
dass die Einkristallkomponente eine Schaufel einer Gasturbine ist.

## Claims

1. Nickel-base superalloy, in particular for the. fabrication of monocrystalline components, comprising (measured in wt %) : 6.0-6.8% of Cr, 8.0-10.0% of Co, 0.5-0.7% of Mo, 6.2-6.6% of W, 2.7-3.2% of Re, 5.4-5.8% of Al, 0.5-0.9% of Ti, 7.2-7.8% of Ta, 0.15-0.3% of Hf, 0.02-0.04% of C, 40-100 ppm of B, optionally 15-50 ppm of Mg, 0-400 ppm of Y, the remainder being nickel with impurities,
wherein the ratio (Ta + 1.5 Hf + 0.5 Mo - 0.5 Ti)/(W + 1.2 Re) ≥ 0.7.

2. Nickel-base superalloy according to Claim 1, characterized by a composition comprising (in wt %): 6.4-6.6% of Cr, 9.4-9.6% of Co, 0.6% of Mo, 6.4-6.6% of W, 3.0-3.2% of Re, 5.6% of Al, 0.6-0.9% of Ti, 7.2-7.5% of Ta, 0.15-0.2% of Hf, 0.02-0.03% of C, 50-60 ppm of B, the remainder being nickel with impurities.

3. Nickel-base superalloy according to Claim 1 or 2, characterized in that 15-50 ppm of Mg and/or 10-400 ppm of Y are present.

4. Nickel-base superalloy monocrystalline component, comprising (measured in wt %): 6.0-6.8% of Cr, 8.0-10.0% of Co, 0.5-0.7% of Mo, 6.2-6.6% of W, 2.7-3.2% of Re, 5.4-5.8% of Al, 0.5-0.9% of Ti, 7.2-7.8% of Ta, 0.15-0.3% of Hf, 0.02-0.04% of C, 40-100 ppm of B, optionally 15-50 ppm of Mg, 0-400 ppm of Y, the remainder being nickel with impurities,
wherein the ratio (Ta + 1.5 Hf + 0.5 Mo - 0.5 Ti)/(W + 1.2 Re) ≥ 0.7.

5. Nickel-base superalloy monocrystalline component according to Claim 4, characterized by a composition comprising (in wt %) : 6.4-6.6% of Cr, 9.4-9.6% of Co, 0.6% of Mo, 6.4-6.6% of W, 3.0-3.2% of Re, 5.6% of Al, 0.6-0.9% of Ti, 7.2-7.5% of Ta, 0.15-0.2% of Hf, 0.02-0.03% of C, 50-60 ppm of B, the remainder being nickel with impurities.

6. Nickel-base superalloy monocrystalline component according to Claim 4 or 5, characterized in that 15-50 ppm of Mg and/or 10-400 ppm of Y are present.

7. Nickel-base superalloy monocrystalline component according to Claim 4 or 5, characterized in that monocrystalline component is a blade of a gas turbine.

## Revendications

1. Superalliage à base de nickel, en particulier pour la fabrication de composants monocristallins, comprenant (mesuré en % en poids) :
6,0-6,8% de Cr, 8,0-10,0% de Co, 0,5-0,7% de Mo, 6,2-6,6% de W, 2,7-3,2% de Re, 5,4-5,8% d'Al, 0,5-0,9% de Ti, 7,2-7,8% de Ta, 0,15-0,3% de Hf, 0,02-0,04% de C, 40-100 ppm de B, facultativement 15-50 ppm de Mg, 0-400 ppm de Y, le reste étant du nickel avec des impuretés, le rapport (Ta + 1,5 Hf + 0,5 Mo - 0,5 Ti)/(W + 1,2 Re) étant ≥ 0,7.

2. Superalliage à base de nickel suivant la revendication 1, caractérisé par une composition constituée (en % en poids) de :
6,4-6,6% de Cr, 9,4-9,6% de Co, 0,6% de Mo, 6,4-6,6% de W, 3,0-3,2% de Re, 5,6% d'Al, 0,6-0,9% de Ti, 7,2-7,5% de Ta, 0,15-0,2% de Hf, 0,02-0,03% de C, 50-60 ppm de B, le reste étant du nickel avec des impuretés.

3. Superalliage à base de nickel suivant la revendication 1 ou 2, caractérisé en ce que 15-50 ppm de Mg et/ou 10-400 ppm de Y sont présents.

4. Composant monocristallin en superalliage à base de nickel, constitué (mesuré en % en poids) de :
6,0-6,8% de Cr, 8,0-10,0% de Co, 0,5-0,7% de Mo, 6,2-6,6% de W, 2,7-3,2% de Re, 5,4-5,8% d'Al, 0,5-0,9% de Ti, 7,2-7,8% de Ta, 0,15-0,3% de Hf, 0,02-0,04% de C, 40-100 ppm de B, facultativement 15-50 ppm de Mg, 0-400 ppm de Y, le reste étant du nickel avec des impuretés, le rapport (Ta + 1,5 Hf + 0,5 Mo - 0,5 Ti)/(W + 1,2 Re) étant ≥ 0,7.

5. Composant monocristallin en superalliage à base de nickel suivant la revendication 4, caractérisé par une composition constituée (en % en poids) de :
6,4-6,6% de Cr, 9,4-9,6% de Co, 0,6% de Mo, 6,4-6,6% de W, 3,0-3,2% de Re, 5,6% d'Al, 0,6-0,9% de Ti, 7,2-7,5% de Ta, 0,15-0,2% de Hf, 0,02-0,03% de C, 50-60 ppm de B, le reste étant du nickel avec des impuretés.

6. Composant monocristallin en superalliage à base de nickel suivant la revendication 4 ou 5, caractérisé en ce que 15-50 ppm de Mg et/ou 10-400 ppm de Y sont présents.

7. Composant monocristallin en superalliage à base de nickel suivant la revendication 4 ou 5, caractérisé en ce que le composant monocristallin est une aube d'une turbine à gaz.
